# EUROPEAN PATENT APPLICATION

(11) **EP 2 713 358 A1**
(43) Date of publication of application: **02.04.2014**
(21) Application number: 13161938.9
(22) Date of filing: 02.04.2013
(51) Int. Cl.: G09G 3/20, H01L 27/02

(54) **Driving circuit for flat panel display device**

(30) Priority: 26.09.2012 KR 20120107162
(71) Applicant: Samsung Display Co., Ltd., Yongin-City, Gyeonggi-Do, 446-711 (KR)
(72) Inventor: Jo, Hyeon-Ja, 446-711 Yongin-City (KR)
(74) Representative: Gulde Hengelhaupt Ziebig & Schneider

(57) **Abstract**

An amplifier circuit (140, 140a, 140b) for a driving circuit (100) for a flat panel display device and a driving circuit (100) for a flat panel display device are disclosed. In one aspect, the amplifier circuit (100) includes a first region (10) having a first width (W1) and a first length (L1), a second region (20) on one side of the first region (10) and having the first width (W1) and the first length (L1), and a third region (30) on one side of the second region (20) and having a second width (W2) and a second length (L2), wherein the second width (W2) and the second length (L2) are different from the first width (W1) and the first length (L1). The amplifier circuit (140, 140a, 140b) also includes a fourth region (40) on one side of the third region (30) and having the second width (W2) and the second length (L2), wherein each region (10, 20, 30, 40) has one or more transistors of only one type.

## Description

### CROSS-REFERENCE TO RELATED APPLICATIONS

This application claims priority to and the benefit of Korean Patent Application No. 10-2012-0107162, filed on September 26, 2012, in the Korean Intellectual Property Office.

### BACKGROUND

### Field

The disclosed technology relates to a flat panel display device, and more particularly, to a layout of a driving circuit used in a flat panel display device.

### Description of the Related Technology

Generally, a flat panel display device such as a liquid crystal display (LCD), an organic light emitting diode (OLED), and the like, includes a display panel in which a plurality of pixels are arranged, and a driving circuit for displaying an image on the display panel by driving the plurality of pixels. Since the driving circuit generally includes an integrated circuit, it is called a display driver IC (DDI).

The display panel includes pixels connected to each other in, for example, a matrix. Each pixel is at least partially between two scan lines and two date lines, and the driving circuit (DDI) includes a scan driving circuit for driving the scan lines and a data driving circuit for driving the data lines. Scan signals are sequentially supplied from the scan driving circuit to the plurality of scanning lines, such that the pixel is selected, and data signals are supplied from the data driving circuit to the data line connected with the selected pixel, such that an image is displayed.

The driving circuit is configured to receive grayscales voltages, corresponding to 64 grayscale, 128 grayscale, 256 grayscale, and the like, from a grayscales voltage generator and select one of the grayscale voltages according to image data input from the outside to supply the selected grayscale voltage to a corresponding data line.

In order to perform an operation as described above, the driving circuit includes a digital to analog converter converting digital image data into an analog signal and a channel amplifier for transmitting the selected grayscale voltage to the data line.

Generally, several hundred to several thousand channel amplifiers are required. In addition, since the digital to analog converter and the channel amplifier include a large number of thin film transistors (TFTs) and complicated wiring, they occupy a large layout area.

Recently, in accordance with a continuous increase in resolution of the flat panel display device, the number of scan lines and data lines has increased. Therefore, the area occupied by the driving circuit has rapidly increased. However, since the area occupied by the driving circuit in the flat panel display device is limited, it is difficult to efficiently layout (design) the driving circuit in the limited area.

### SUMMARY OF CERTAIN INVENTIVE ASPECTS

One inventive aspect is an amplifier circuit according to claim 1 for a driving circuit for a flat panel display device. The amplifier circuit includes a first region having a first width and a first length, a second region on one side of the first region and having the first width and the first length, and a third region on one side of the second region and having a second width and a second length, wherein the second width and the second length are different from the first width and the first length. The driving circuit also includes a fourth region on one side of the third region and having the second width and the second length, wherein each region has one or more transistors of only one type. Advantageous embodiments of the amplifier circuit are specified in the claims dependent on claim 1.

Another inventive aspect is a driving circuit according to claim 10 for a flat panel display device. The driving circuit includes first and second amplifier circuits according to the invention. Advantageous embodiments of the driving circuit are specified in the claims dependent on claim 10.

### BRIEF DESCRIPTION OF THE DRAWINGS

The accompanying drawings, together with the specification, illustrate exemplary embodiments, and, together with the description, serve to explain certain aspects and principles of the present invention.

FIG. 1 is a schematic plan view describing a driving circuit for a flat panel display device according to some exemplary embodiments.

FIG. 2 is a plan view describing a channel amplifier according to some embodiments. the exemplary embodiment.

FIG. 3 is a plan view describing a arrangement structure of the channel amplifier according to some embodiments.

FIGS. 4 and 5 are plan views showing examples of arrangements of the channel amplifiers and arrangements of the respective regions according to some embodiments.

FIG. 6 is a plan view showing the arrangement structure of FIG. 4 or 5 in more detail.

FIG. 7 is a plan view describing a comparative example.

### DETAILED DESCRIPTION OF CERTAIN INVENTIVE EMBODIMENTS

Hereinafter, certain exemplary embodiments are described with reference to the accompanying drawings. When a first element is described as being coupled to a second element, the first element may be directly coupled to the second element or may be indirectly coupled to the second element via a third element. Further, some of the elements that are not essential to the complete understanding of the invention are omitted for clarity. Also, like reference numerals generally refer to like elements throughout.

Hereinafter, certain embodiments are described with reference to the accompanying drawings. The following exemplary embodiments may be modified in many different forms so that those skilled in the art may implement the various features and aspects, and the scope of the present invention should not be limited to the embodiments to be described below.

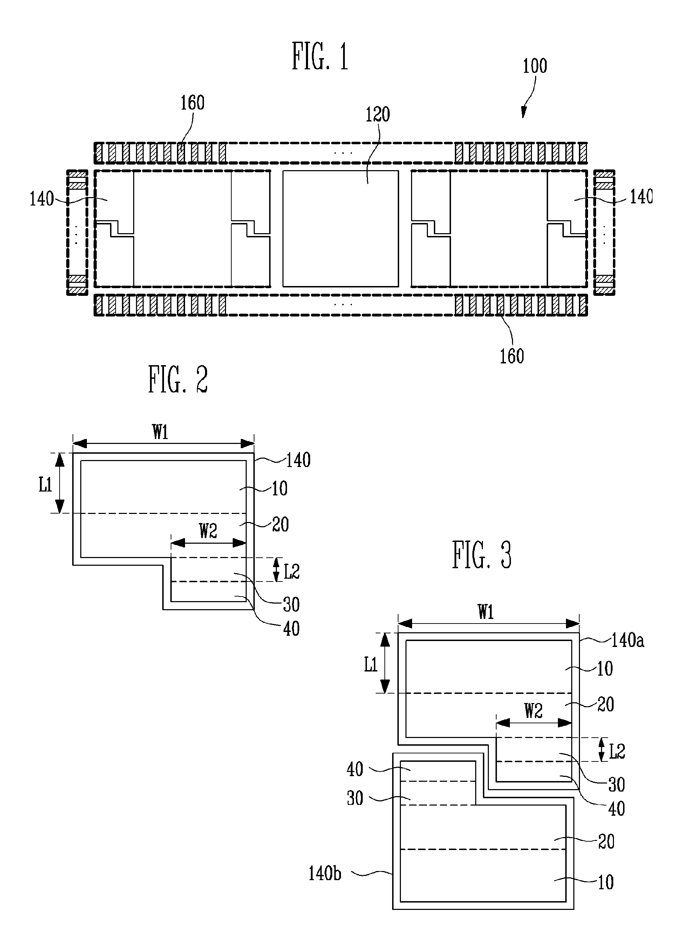

FIG. 1 is a schematic plan view describing a driving circuit of a flat panel display device according to an exemplary embodiment. Referring to FIG. 1, the driving circuit 100 includes a circuit unit 120 supplying power and processing a signal and a channel amplifier 140 amplifying the processed signal and outputting the amplified signal through a pad unit 160. Several hundred to several thousand of channel amplifiers 140 may be provided according to the resolution of the flat panel display device and may be disposed in the vicinity of the circuit unit 120.

In the case in which the driving circuit 100 is operated as a data driving circuit, it may be configured to receive grayscale voltages corresponding to 64 grayscale, 128 grayscale, 256 grayscale, and the like, from a grayscale voltage generator (not shown) and select a grayscale voltage according to image data input from the outside to supply the grayscale voltage to a corresponding data line.

The circuit unit 120 supplies power for operating the driving circuit 100 and processes the image data input from the outside to generate the data signal, and the channel amplifier 140 amplifies the data signal and transfers the amplified signal to a corresponding data line.

FIG. 2 is a plan view illustrating a channel amplifier 140 according to an exemplary embodiment. Referring to FIG. 2, the channel amplifier 140 includes a first region 10 having a first width W1 and a first length L1, a second region 20 disposed on one side of the first region 10 and having the first width W1 and the first length L1, a third region 30 on one side of the second region 20 and having a second width W2 and a second length L2 different from the first width W1 and the first length L1, respectively, and a fourth region 40 on one side of the third region 30 and having the second width W2 and the second length L2.

In this embodiment, the first width W1 and first length L1 are larger than the second width W2 and the second length L2, respectively, and the first width W1 is equal to or greater than the sum of the first length L1 and the second length L2.

Different types of transistors (TFTs) are disposed in the first region 10, the second region 20, the third region 30, and fourth region 40, respectively. N-type transistors or P-type transistors are divided into a group and disposed as the different types of transistors (TFTs) at the first to fourth regions 10 to 40, thereby making it possible to facilitate a layout (design) and effectively reduce the area.

For example, N-type transistors may be disposed in the first and third regions 10 and 30 and P-type transistors may be disposed in the second and fourth regions 20 and 40, or the N-type transistors may be disposed in the first and fourth regions 10 and 40 and the P-type transistors may be disposed in the second and third regions 20 and 30.

Alternatively, the P-type transistors may be disposed in the first and third regions 10 and 30 and the N-type transistors may be disposed at the second and fourth regions 20 and 40, or the P-type transistors may be disposed in the first and fourth regions 10 and 40 and the N-type transistors may be disposed in the second and third regions 20 and 30.

Accordingly, in these embodiments, each region has only one type of transistor.

A plurality of transistors at least partly forming circuits for amplifying the data signals and transferring the amplified signals to the plurality of data lines are each either N-type or P-type and are located in the first and second regions 10 and 20, and a plurality of transistors at least partly forming an input circuit and an output circuit are each either N-type or P-type and are located in the third and fourth regions 30 and 40.

It may be advantageous that the channel amplifiers 140 may be arranged at upper and lower portions, as shown in FIG. 3. In this configuration, the first and second regions 10 and 20 at the upper portion of the channel amplifier 140a and the first and second regions 10 and 20 at the lower portion of the channel amplifier 140b are vertically symmetrical to each other, and the third and fourth regions 30 and 40 of the channel amplifier 140a at the upper portion and the third and fourth regions 30 and 40 of the channel amplifier 140b at the lower portion are horizontally symmetrical to each other.

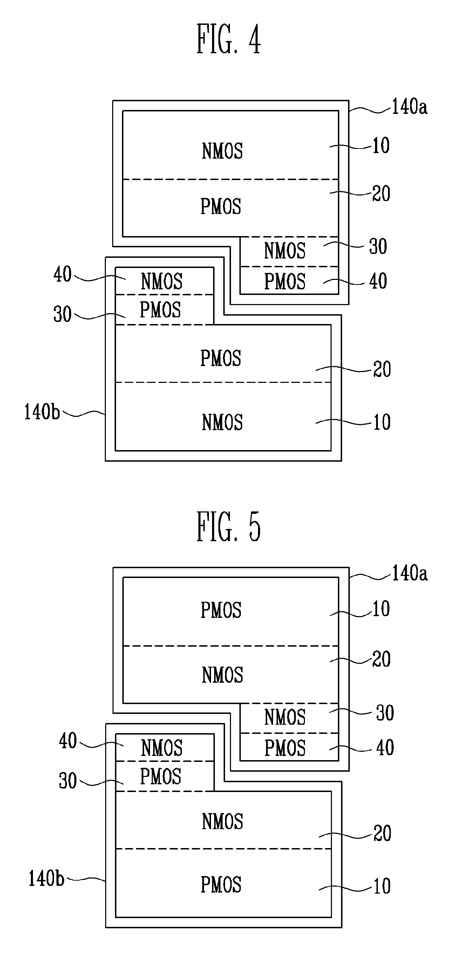

FIGS. 4 and 5 are plan views showing examples of arrangements of the channel amplifiers 140a and 140b according to an exemplary embodiment.

Referring to FIG. 4, N-type transistors (NMOS) are in the first and third regions 10 and 30 of the channel amplifier 140a at the upper portion and P-type transistors (PMOS) are in the second and fourth regions 20 and 40 thereof, and the N-type transistors (NMOS) are in the first and fourth regions 10 and 40 of the channel amplifier 140b at the lower portion and the P-type transistors (PMOS) are in the second and third regions 20 and 30 thereof.

Referring to FIG. 5, the P-type transistors (PMOS) are in the first and fourth regions 10 and 40 of the channel amplifier 140a at the upper portion and the N-type transistors (NMOS) are in the second and third regions 20 and 30 thereof, and the P-type transistors (PMOS) are in the first and third regions 10 and 30 of the channel amplifier 140b at the lower portion and the N-type transistors (NMOS) are in the second and fourth regions 20 and 40 thereof.

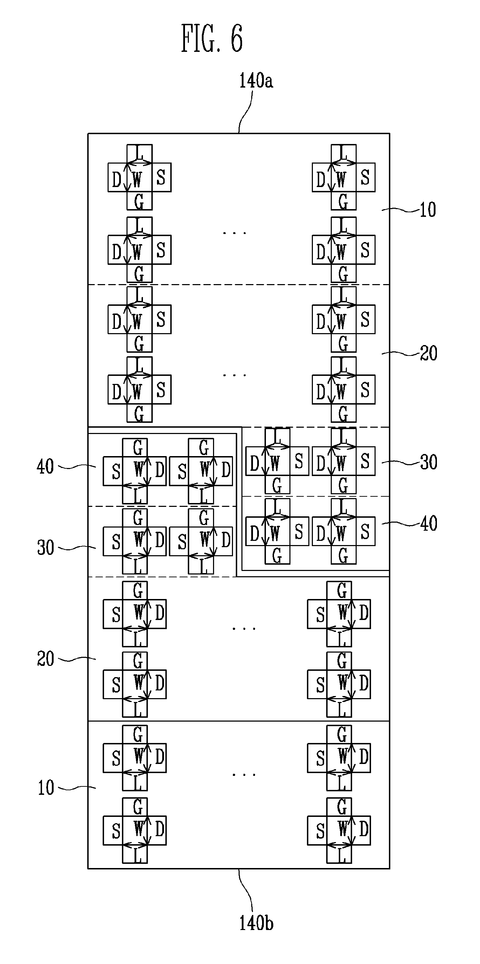

FIG. 6, which is a plan view showing the arrangement structure of FIG. 4 or FIG. 5 in more detail, shows an example of a structure in which gate (G) electrodes, source (S) electrodes, drain (D) electrodes, and wirings of the transistors (NMOS and PMOS) are in the first to fourth regions 10 to 40.

It may be advantageous that the driving circuit in the flat panel display device has a rectangular shape in which one side (width) is larger than another side (length). In accordance with an increase in a resolution of the flat panel display device, a larger number of channel amplifiers are required, such that a size of the driving circuit is inevitably increased. However, when the size is increased only at one side, several problems are generated.

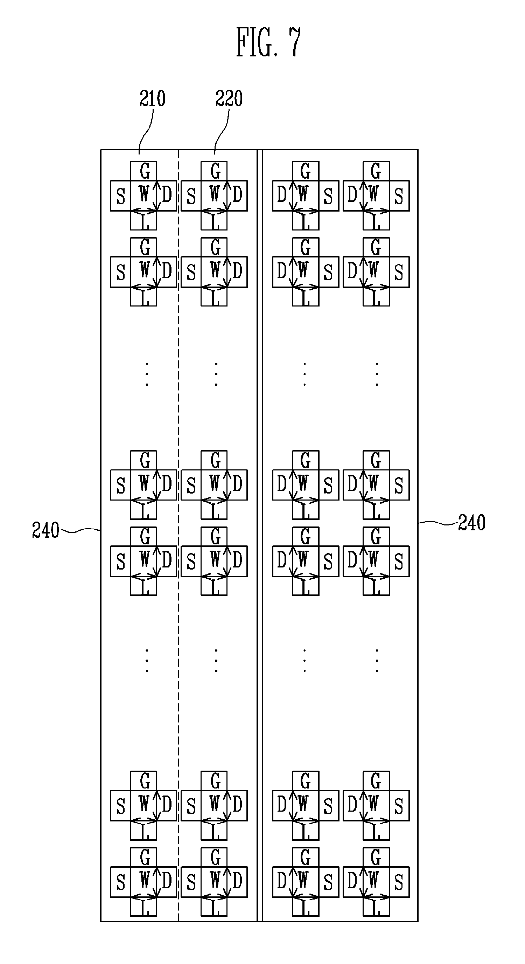

For example, as shown in FIG. 7, when the first region 210 and the second region 220 are in parallel with each other in the length direction, there is a limitation in increasing the length. In addition, a connection path between an N-type transistor of the first region 210 and a P-type transistor of the second region 220 is sufficiently short; however, a connection path between the transistors within each region 210 or 220 is undesirably long, and a channel width or length of each transistor is limited. As the number of channel amplifiers increases, these problems become more significant.

On the other hand, since the channel amplifier (See FIG. 6) according to the exemplary embodiments has a width greater than that of the channel amplifier of FIG. 7 and a length shorter than that of the channel amplifier of FIG. 7, both the connection path between the transistor of the first region 10 and the transistor of the second region 20 and the connection path between the transistors within each region 10 or 20 may become short. In addition, since the width of the respective regions 10 and 20 is wide, the channel width or length of each transistor may be effectively chosen and the area efficiently used. The channel amplifier of the FIG. 6 may have use less area as compared to the channel amplifier of FIG. 7 by about 20%.

In addition, in the case in which the channel amplifier (See FIG. 6) according to the exemplary embodiment is used, since the third and four regions 30 and 40 are adjacent to each other between the respective channel amplifiers 140a and 140b, when an input circuit and an output circuit are disposed at the third and four regions 30 and 40, an offset of the transistor is minimized and distances from the respective channel amplifiers to the pad unit 160 are substantially the same as each other, such that all of the channel amplifiers may maintain uniform input/output characteristics.

Since the width and the length of the channel amplifier according to the exemplary embodiment are substantially the same as each other, both of the connection path between the transistor of one region and the transistor of another region and the connection path between the transistors within of the respective regions may be short. In addition, since the widths of the respective regions are sufficient, the channel width or length of the channel of the each transistor may be sufficient and the space may also be efficiently used. Further, since the input circuit and output circuit are between each channel amplifier, an offset of the transistor is minimized, and the distances from the each channel amplifier to the pad unit are substantially the same as each other, such that all channel amplifiers may maintain uniform input/output characteristics.

While various aspects and features have been described in connection with certain exemplary embodiments, it is to be understood that the invention is not limited to the disclosed embodiments, but, on the contrary, is intended to cover various modifications and equivalent arrangements.

## Claims

1. An amplifier circuit (140, 140a, 140b) for a driving circuit (100) for a flat panel display device, the driving circuit comprising:
a first region (10) having a first width (W1) and a first length (L1);
a second region (20) on one side of the first region and having the first width (W1) and the first length (L1);
a third region (30) on one side of the second region and having a second width and (W2) a second length (L2), wherein the second width (W2) and the second length (L2) are different from the first width (W1) and the first length (L1); and
a fourth region (40) on one side of the third region and having the second width (W2) and the second length (L2),
wherein each region (10, 20, 30, 40) has one or more transistors of only one type.

2. The amplifier circuit (140, 140a, 140b) according to claim 1, wherein the first width (W1) and the first length (L1) are greater than the second width (W2) and the second length (L2), respectively.

3. The amplifier circuit (140, 140a, 140b) according to claim 1 or 2, wherein the first width (W1) is equal to or greater than the sum of the first length (L1) and the second length (L2).

4. The amplifier circuit (140, 140a, 140b) according to one of the preceding claims, wherein the first and third regions (10, 30) comprise transistors of a first type andthe second and fourth regions (20, 40) comprise transistors of a second type different from the first type.

5. The amplifier circuit (140, 140a, 140b) according to one of claims 1- 3, wherein first and fourth regions (10, 40) comprise transistors of a first type andthe second and third regions (20, 30) comprise transistors of a second type different from the first type.

6. The amplifier circuit (140, 140a, 140b) according to claim 4 or 5, wherein the transistors of the first type are P-type transistors.

7. The amplifier circuit (140, 140a, 140b) according to claim 4 or 5, wherein the transistors of the second type are P-type transistors.

8. The amplifier circuit (140, 140a, 140b) according to one of the preceding claims, wherein an input circuit is at least partly formed by the transistors of the third region (30) and an output circuit is at least partly formed by the transistors of the fourth region (40).

9. The amplifier circuit (140, 140a, 140b) according to one of claims 1 to 7, wherein an output circuit is at least partly formed by the transistors of the third region (30) and an input circuit is at least partly formed by the transistors of the fourth region (40).

10. The amplifier circuit (140, 140a, 140b) according to one of the preceding claims, wherein each of the first, second, third, and fourth region has a rectangular shape.

11. A driving circuit (100) comprising a first amplifier circuit (140a) according to one of the preceding claims and a second amplifier circuit (140b) according to one of the preceding claims.

12. The driving circuit (100) according to claim 11, wherein the first regions of the first amplifier circuit (140a) and of the second amplifier circuit (140b) comprise transistors of a same type.

13. The driving circuit (100) according to claim 11 or 12, wherein the third region (30) of the first amplifier (140a) is adjacent to the fourth region (40) of the second amplifier (140b), and wherein the fourth region (40) of the first amplifier (140a) is adjacent to the third region (30) of the second amplifier (140b).

14. The driving circuit (100) according to claim 13 wherein the first and second regions (10, 20) of the first amplifier circuit (140a) and the first and second regions (10, 20) of the second amplifier circuit (140b) are vertically symmetrical to each other, and the third and fourth regions (30, 40) of the first amplifier circuit (140a) and the third and fourth regions (30, 40) of the second amplifier circuit (140b) are horizontally symmetrical to each other.

15. The driving circuit (100) according to one of claims 11 to 14 wherein the driving circuit (100) has a rectangular shape in which a width of the driving circuit (100) is larger than a length of the driving circuit (100).
